# EUROPÄISCHE PATENTSCHRIFT

(11) **EP 0 661 666 B1**
(45) Veröffentlichungstag und Bekanntmachung des Hinweises auf die Patenterteilung: **22.05.2002**
(21) Anmeldenummer: 94120463.8
(22) Anmeldetag: 22.12.1994
(51) Int. Cl.: G06K 19/077

(54) **Verfahren zur Herstellung von Ausweiskarten**
Process for the production of an identity card
Méthode de fabrication d'une carte d'identité

(30) Priorität: 23.12.1993 DE 4344297
(43) Veröffentlichungstag der Anmeldung: 05.07.1995
(73) Patentinhaber: Giesecke & Devrient GmbH, 81677 München (DE)
(72) Erfinder: Hoppe, Joachim, D-81667 München (DE); Hohmann, Arno, D-81369 München (DE)
(74) Vertreter: Klunker . Schmitt-Nilson . Hirsch

(56) Entgegenhaltungen:
- EP-A- 0 201 952
- EP-A- 0 370 114
- DE-A- 3 122 981
- FR-A- 2 673 039
- US-A- 5 122 860
- PATENT ABSTRACTS OF JAPAN vol. 14 no. 235 (M-975) ,18.Mai 1990 & JP-A-02 062296 (MATSUSHITA ELECTRIC IND CO LTD) 2.März 1990,

## Beschreibung

Die Erfindung betrifft ein Verfahren zur Herstellung von Ausweiskarten, gemäß dem Oberbegriff des Anspruchs 1. Ferner betrifft die Erfindung eine Ausweiskartenserie und eine Ausweiskarte.

Ausweiskarten mit integrierten Schaltkreisen werden in zunehmendem Maße in Form von Kreditkarten, Bankkarten, Barzahlungskarten und dergleichen in den verschiedensten Dienstleistungssektoren, beispielsweise im bargeldlosen Zahlungsverkehr sowie im innerbetrieblichen Bereich eingesetzt. Ein Großteil der Ausweiskarten wird in der sog. "Montagetechnik" hergestellt. Bei diesem Verfahren wird ein Kartenkörper mit Aussparung gefertigt, in welchem der integrierte Schaltkreis mittels eines Trägerelements eingebracht und beispielsweise mittels einer Klebeschicht befestigt wird.

Aus der DE-OS 31 22 981 ist z. B. ein Verfahren zur Herstellung einer Ausweiskarte mit einem pfennigförmigen Trägerelement bekannt. Zunächst wird ein Kartenkörper, bestehend aus einer Kernschicht und einer vorder- und rückseitigen Deckschicht, bereitgestellt. Der Kartenkörper wird in Laminiertechnik erstellt und weist noch keine Aussparung auf. Zwischen der Kernschicht und der rückseitigen Deckschicht befindet sich bereichsweise eine Trennschicht, die verhindert, daß sich die Kernschicht mit der rückseitigen Deckschicht beim Laminieren verbindet. Die Trennschicht wird dazu genutzt, um aus dem fertiggestellten Kartenkörper einen pfennigförmigen Pfropfen auszustanzen und zu entfernen, so daß dadurch im Kartenkörper eine sacklochförmige Aussparung entsteht. In die Aussparung wird das pfennigförmige Trägerelement ganzflächig mit dem Boden der Aussparung mittels einer Klebeschicht verbunden. Die Abmessungen der Aussparung entsprechen der Form und Größe des Trägerelements.

Aus der EP-A1 0 493 738 ist beispielsweise ein Verfahren zur Herstellung einer Ausweiskarte mit einem Trägerelement bekannt. Das Trägerelement weist wenigstens einen integrierten Schaltkreis auf, der elektrisch leitend über Verbindungselemente mit Kopplungselementen verbunden ist, die zur Kommunikation des integrierten Schaltkreises mit externen Geräten dienen. Der integrierte Schaltkreis und die elektrisch leitenden Verbindungselemente werden mit einer Gußmasse vergossen. Das Trägerelement wird mit Hilfe einer thermoaktivierbaren Klebeschicht in eine dafür vorgesehene zweistufige Aussparung des Kartenkörpers eingeklebt. Die Abmessungen der zweistufigen Aussparung sind hierbei so gewählt, daß sie der Form und Größe des Trägerelements entsprechen.

Die genannten Druckschriften zeigen, daß die Abmessungen der Aussparung exakt der Form und Größe des jeweilig in die Aussparung einzusetzenden Trägerelements entsprechen, wobei die Trägerelemente mittels einer Klebeschicht direkt mit den Kartenkörpern verbunden werden.

Da für Trägerelemente mit unterschiedlichen integrierten Schaltkreisen, die sich in Größe und Form unterscheiden, unterschiedliche Aussparungen in den Kartenkörpern zu erzeugen sind, muß zur Herstellung der Kartenaussparung ein speziell an die Form und Größe des zu verwendenden Trägerelements angepaßtes Werkzeug bereitgestellt werden. So wird z. B. eine spezielle Spritzgußform zur Erzeugung der Aussparung benötigt, wenn der Kartenkörper in Spritzgußtechnik

Aus der französischen Offenlegungsschrift FR-A 2 673 039 ist ein geschütztes Modul zum Einbau in einen Kartenkörper bekannt. Das Modul enthält einen integrierten Schaltkreis, der geschützt innerhalb einer Haube angeordnet ist. Der integrierte Schaltkreis ist elektrisch leitend mit Kontaktelementen verbunden. Auch bei diesem Modul ist es notwendig, die Aussparung im Kartenkörper so zu wählen, daß sie der Form und Größe des Moduls entspricht. hergestellt wird. Darüber hinaus wird die Lagerhaltung von Kartenkörpern mit unterschiedlichen Aussparungen erschwert, da nicht abzusehen ist, ob sich die Form und Größe der zu verwendenden integrierten Schaltkreise ändert und dadurch nicht verwendbare Restbestände von Kartenkörpern mit speziellen Aussparungen anfallen können. Außerdem wird durch die unterschiedlichen Aussparungen in den Kartenkörpern eine einfache Umstellung in der Produktion von Ausweiskarten mit unterschiedlich geformten Trägerelementen erschwert, da weder die notwendigen Werkzeuge zur Fertigung der speziellen Aussparungen der Kartenkörper noch entsprechende Lagerbestände verfügbar sind. Schließlich können bei kleinen Serien von Ausweiskarten mit einem speziellen Trägerelement hohe Kosten entstehen, da die Aussparung des Kartenkörpers mit einem speziellen Werkzeug gesondert gefertigt werden muß.

Dies alles bedeutet, daß durch die Herstellung einer speziellen, den Abmessungen des Trägerelements angepaßten Aussparung die Flexibilität bei der Herstellung von Ausweiskarten mit unterschiedlichen Trägerelementen beeinträchtigt ist. Weiterhin hat die direkte Verbindung der Trägerelemente mit dem Kartenkörper mittels einer Klebeschicht den Nachteil, daß ein relativ starrer Verbund aus Trägerelement und Kartenkörper entsteht, der bei Biegebeanspruchung der Karte zu hohen mechanischen Belastungen des integrierten Schaltkreises und der elektrischen Verbindungsleiter führt.

Der Erfindung liegt somit die Aufgabe zugrunde, die Herstellung von Ausweiskarten bezüglich des Einbaus unterschiedlicher Trägerelemente mit integrierten Schaltkreisen in die Kartenkörper zu verbessern.

Die Aufgabe wird durch die in den nebengeordneten Ansprüchen 1, 9 und 11 angegebenen Merkmale gelöst.

Der Grundgedanke der Erfindung besteht darin, die Kartenkörper der Ausweiskarten unabhängig von der Form und Größe der in die Ausweiskarten einzusetzenden integrierten Schaltkreise mit einer einheitlichen Aussparung zu versehen und zur Aufnahme der unterschiedlichen integrierten Schaltkreise flexible Adapterelemente vorzusehen, deren Außenabmessungen der Form und Größe der standardisierten Aussparung der Kartenkörper angepaßt sind.
Zur Aufnahme der Trägerelemente werden die Adapterelemente mit Öffnungen versehen, die hinsichtlich der Form und Größe im wesentlichen den äußeren Abmessungen des jeweils zur Anwendung kommenden Trägerelements entsprechen. Mit Hilfe der hinsichtlich der Außenabmessungen einheitlich ausgebildeten Adapterelemente können somit auch unterschiedliche Trägerelemente in die einheitliche Aussparung der Kartenkörper eingebaut werden.

Die mit der Erfindung erzielten Vorteile bestehen insbesondere darin, daß die Herstellung von Ausweiskarten mit unterschiedlichen Trägerelementen durch die Verwendung eines standardisierten Ausgangsproduktes mit einer einheitlichen Kartenaussparung in Verbindung mit einem Adapterelement flexibel gestaltet werden kann. Dadurch ist es möglich, vorgefertigte Kartenkörper mit Aussparungen in beliebig großen Stückzahlen zu produzieren und zu lagern, da sie unabhängig vom einzubauenden Trägerelement verwendbar sind. Darüber hinaus entfällt durch die Bereitstellung von Kartenkörpern mit einheitlichen Aussparungen und den dazu entsprechenden Adapterelementen die Notwendigkeit, spezielle Werkzeuge bereitstellen zu müssen, wodurch letztendlich die Herstellungskosten der Ausweiskarten, insbesondere bei kleineren Auflagen gesenkt werden können. Darüber hinaus kann die standardisierte Aussparung in den Kartenkörpern eine einfache Form aufweisen, so daß sie in einfacher Art und Weise rationell mit geringen Toleranzabhängigkeiten zu erstellen ist. Die obengenannten Vorteile werden ohne Qualitätseinbußen bei der Herstellung von Ausweiskarten erreicht.

Gemäß einem bevorzugten Ausführungsbeispiel der Erfindung wird das Trägerelement mit dem Adapterelement zu einem Modul verbunden, das in Form und Größe im wesentlichen den Abmessungen der standardisierten Aussparung im Kartenkörper entspricht. Das entstandene Modul aus Trägerelement und Adapterelement wird in der Aussparung des Kartenkörpers mit Hilfe einer Klebeschicht befestigt. Bei diesem Ausführungsbeispiel ist das Adapterelement integrierter Bestandteil des elektronischen Moduls. Es ist aber auch möglich, zuerst das Adapterelement als separates Element in die standardisierte Aussparung des Kartenkörpers einzukleben, so daß eine an die Form und Größe des jeweilig einzusetzenden Trägerelements angepaßte Aussparung in dem Kartenkörper entsteht. Anschließend kann dann das Trägerelement z. B. mit Hilfe einer Klebeschicht mit dem Adapterelement verbunden werden.

Die Auswahl des Materials für das Adapterelement kann unabhängig von dem zur Herstellung des Trägerelements eingesetzten Materialien, die bestimmten Anforderungen genügen müssen, vorgenommen werden. Vorzugsweise wird für das Adapterelement ein elastisches oder plastisch leicht deformierbares Material, beispielsweise Weich-PVC-Schaum, Polyäthylen-Schaum oder Elastomer-Schaum gewählt. Durch die Verwendung eines elastischen, leicht deformierbaren Materials für das Adapterelement wird bei der Herstellung der Ausweiskarte eine Entlastung des integrierten Schaltkreises und der elektrisch leitenden Verbindungselemente vom Schaltkreis zu den Kontaktflächen erreicht. Auch wird durch die elastische Pufferwirkung des Adapterelementes eine Entlastung des integrierten Schaltkreises samt der Leiterdrähte bei Biegebeanspruchung der Karte im täglichen Gebrauch erzielt, so daß eine hohe elektrische Zuverlässigkeit der Ausweiskarte gewährleistet ist. Auch ist eine Entlastung des integrierten Schaltkreises gegen Biegestreß mit Hilfe des Adapterelementes dadurch möglich, daß dieser nur partiell, d. h. gelenkartig mit dem Kartenkörper verbunden wird.

Weitere Ausführungsformen und Vorteile der Erfindung ergeben sich aus den Unteransprüchen sowie der Zeichnungen. Darin zeigen:
- Fig. 1: die Aufsicht auf eine Ausweiskarte mit einem elektronischen Modul,
- Fig. 2 bis 4: verschiedene Ausführungsbeispiele einer Ausweiskarte jeweils im Querschnitt,
- Fig. 5: ein Metallband mit vorgestanztem Kontaktlayout,
- Fig. 6: ein elektronisches Modul im Querschnitt,
- Fig. 7a und 7b: die Halbzeugfertigung von elektronischen Modulen,
- Fig. 8: ein Verfahren zur Herstellung von Ausweiskarten.

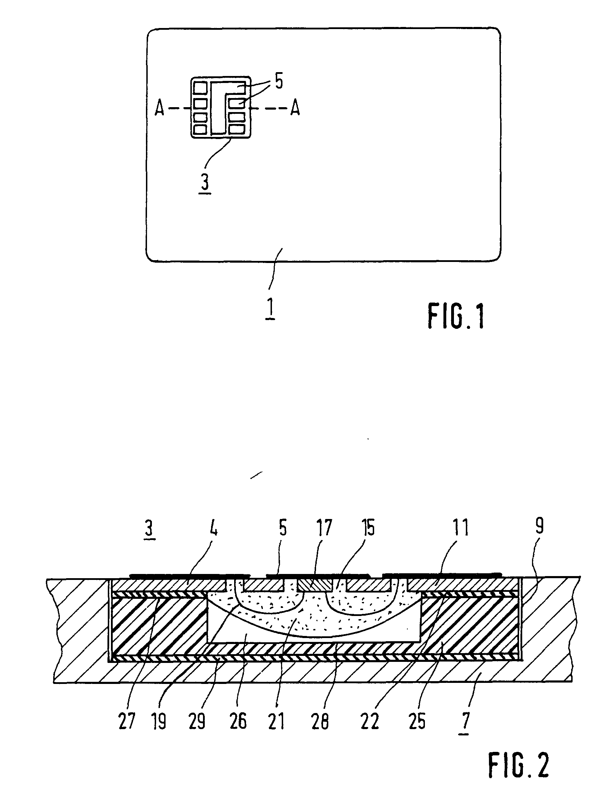

Fig. 1 zeigt eine Ausweiskarte 1 mit elektronischem Modul 3 in der Aufsicht. Das elektronische Modul 3 verfügt über Kopplungselemente 5, die der Kommunikation mit externen Geräten dienen.

Fig. 2 zeigt stark vergrößert und nicht maßstabsgetreu einen Querschnitt entlang der in Fig. 1 strichliniert eingezeichneten
Linie A-A durch die Ausweiskarte 1. Der Kartenkörper 7 hat eine standardisierte Aussparung 9, die unabhängig von der Form und den Abmaßen des in die Aussparung einzusetzenden Trägerelements, immer die gleiche Form und die gleiche Größe aufweist. Der Kartenkörper 7 mit der einheitlichen Aussparung 9 kann in den verschiedensten Techniken gefertigt werden, z. B. in Spritzgußtechnik, wobei die Aussparung bereits beim Spritzgießvorgang mittels einer entsprechenden Gußform berücksichtigt werden kann oder die Aussparung später in den bereits fertiggestellten Kartenkörper eingefräst werden kann. Selbstverständlich ist es auch möglich, den Kartenkörper in Laminiertechnik herzustellen, sowie die Aussparung im Kartenkörper durch Stanzen oder aber durch Einfräsen zu erzeugen. Die obige Aufzählung erhebt keinerlei Anspruch auf Vollständigkeit, vielmehr sind dem Fachmann weitere Techniken geläufig, einen Kartenkörper mit einer Aussparung zu fertigen.

In der standardisierten Aussparung 9 ist ein Trägerelement 4 mit Hilfe eines Adapterelementes 25 mit dem Kartenkörper verbunden. Das in Fig. 2 gezeigte Trägerelement 4 besteht z. B. aus einem Trägerfilm 11 aus Kapton, der auf einer Seite die Kontaktflächen 5 aufweist. Der Trägerfilm 11 weist entsprechend positionierte Fenster 15 zur Aufnahme des integrierten Schaltkreises 17 und zur Hindurchführung der elektrisch leitenden Verbindungselemente 19 vom Schaltkreis 17 zu den Kontaktflächen 5 auf. Zum Schutz vor mechanischen Belastungen sind der integrierte Schaltkreis und die elektrisch leitenden Verbindungselemente mit einer Gußmasse 21 vergossen. Das Trägerelement ist z. B. mittels einer Klebeschicht 22 mit dem Adapterelement 25 verbunden. Das in Fig. 2 gezeigte Adapterelement weist z. B. eine zweistufige Öffnung 26 auf, wobei die Schulterteile 27 der Öffnung im wesentlichen den Trägerfilm 11 und der tiefere Teil 28 der Öffnung im wesentlichen die Gußmasse 21 aufnehmen. Durch die Klebeschicht 22 wird der von Gußmasse freie Teil des Trägerelements auf den Schulterteilen des Adapterelementes verklebt. Das Adapterelement kann wiederum mittels einer Klebeschicht 29 am Boden der standardisierten Aussparung 9 des Kartenkörpers mit diesem verbunden werden.

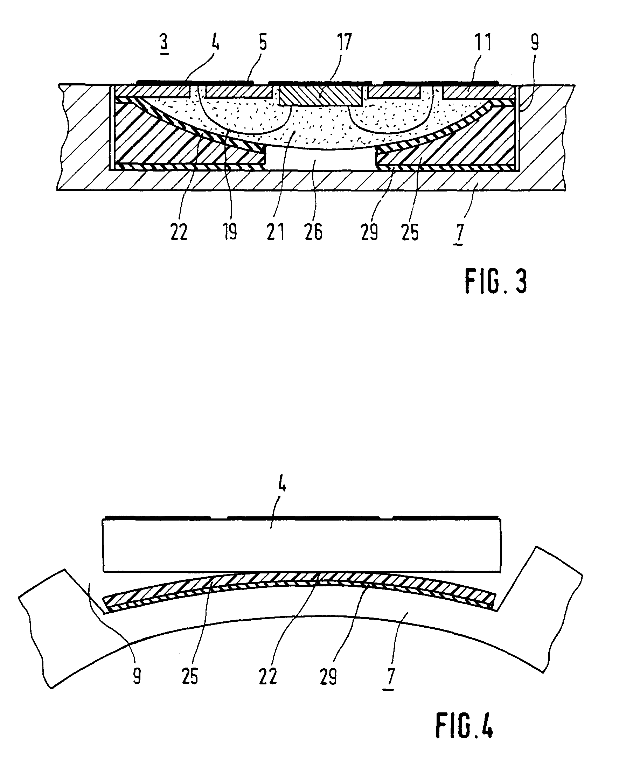

Bei der in der Fig. 3 gezeigten Karte unterscheidet sich das Trägerelement 4 von dem des in Fig. 2 gezeigten dadurch, daß der integrierte Schaltkreis 17 deutlich größer ist, wodurch auch die Ausdehnung der Gußmasse 21 und somit die äußere Form und Größe des Trägerelements 4 unterschiedlich ist. Trotz dieser Unterschiede kann das Trägerelement mit Hilfe eines an die Abmessungen des Trägerelements 4 angepaßten Adapterelementes 25, das zur Aufnahme des Trägerelements z. B. mit einer entsprechenden Öffnung 26 versehen ist, in die standardisierte Aussparung 9 des Kartenkörpers 7 eingesetzt werden. Die in Fig. 3 gezeigte Öffnung 26 des Adapterelementes ist derart ausgebildet, daß neben dem Teil des Trägerelements, der frei von der Gußmasse 21 ist, auch noch wenigstens ein Teil der Gußmasse mit dem Adapterelement mit Hilfe einer Klebeschicht 22 verbunden werden kann. Dies ermöglicht eine gute Verbindung zwischen dem Trägerelement und dem Adapterelement auch dann, wenn, wie im gezeigten Beispiel, der von Gußmasse freie Teil des Trägerelements eine relativ kleine Fläche darstellt. Das Adapterelement kann wiederum z. B. mittels einer Klebeschicht 29 mit dem Boden der standardisierten Aussparung 9 des Kartenkörpers verbunden werden.

Fig. 4 zeigt stark schematisiert eine Ausweiskarte bei Biegebeanspruchung, wobei das Trägerelement 4 mit Hilfe des Adapterelementes 25 gelenkartig in der Aussparung 9 mit dem Kartenkörper 7 verbunden ist. Das Trägerelement wird in diesem Ausführungsbeispiel durch einen sehr großen Chip 4 gebildet. Das Adapterelement ist ganzflächig mit dem Boden der Aussparung des Kartenkörpers verbunden. Die Verbindung mit dem Kartenkörper kann z. B. mittels einer auf dem Adapterelement befindlichen Haftklebeschicht 29 erfolgen. Auf der dem Trägerelement zugewandten Seite ist das Adapterelement, um die gelenkartige Verbindung mit dem Chip zu erhalten, nur partiell, z. B. im mittleren Bereich mit dem Chip verbunden. Diese gelenkartige Verbindung kann im mittleren Bereich mittels einer auf dem Adapterelement angeordneten thermoaktivierbaren Klebeschicht realisiert werden. Die Verbindung des Adapterelementes 25 mit dem Chip 4 zu einem Modul erfolgt vorzugsweise bei der Halbzeugfertigung des Moduls, d. h. vor dem Einbau des Moduls in den Kartenkörper. Durch die gelenkartige Verbindung des Chips mit dem Adapterelement kann eine gute Entlastung des Chips bei hohen Biegebeanspruchungen der Karte erreicht werden. Die hier gezeigte Ausführungsform des Adapterelementes ist insbesondere bei großen Chips vorteilhaft. Aufgrund der Pufferwirkung durch das Adapterelement, welches z. B. aus einer PET-Folie besteht, können keine punktförmigen Deformationen am dünnwandigen Kartenboden, z. B. durch Klebepunkte entstehen.

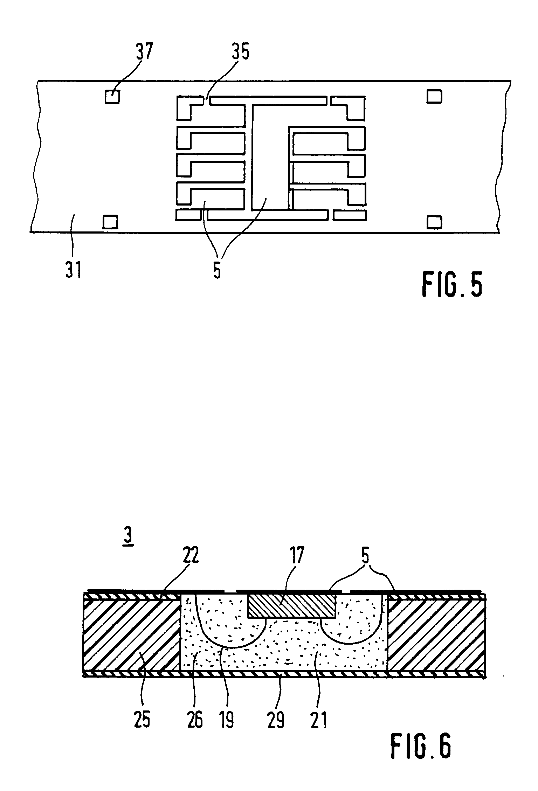

Fig. 5 zeigt in der Aufsicht ein Metallband 31 mit entsprechend vorgestanzten Kontaktflächen 5, wie es zur Herstellung der standardisierten elektronischen Module in der lead-frame-Technik verwendet werden kann. Die Kontaktflächen 5 des Metallbandes, welches z. B. eine Stärke von ca. 50 bis 100 µm aufweist, sind zunächst über Stege 35 mit dem Metallband verbunden. Die Verbindungsstege werden später beim Ausstanzen der einzelnen elektronischen Module durchtrennt. Das Metallband kann, wie alle nachfolgend gezeigten Bänder, zum getakteten Transport Perforationen 37 aufweisen.

Fig. 6 zeigt ein elektronisches Modul im Querschnitt. Das Adapterelement 25 ist hier z. B. mit einer durchgehenden Öffnung 26 mit konstantem Durchmesser versehen. Die Durchgangsöffnung ist so bemessen, daß die eine konstante Dicke aufweisende Gußmasse 21 des Trägerelements vollständig in der Öffnung des Adapterelementes Platz findet. Die hier gezeigte Form der Gußmasse erlaubt somit eine einfache Herstellung der Öffnung des Adapterelementes. Die Kontaktflächen 5 des elektronischen Moduls 3 werden bei diesem Ausführungsbeispiel z. B. aus einem Metallband, wie in Fig. 5 dargestellt, in der lead-frame-Technik durch entsprechendes Stanzen erhalten. Der integrierte Schaltkreis 17 wird mittels eines elektrisch leitenden Klebers auf einem zentralen Bereich der Kontaktflächen aufgeklebt. Dieser zentrale Kontaktbereich kann als Masseanschluß verwendet werden. Diese Technik hat den Vorteil, daß auf einen separaten Trägerfilm zur Aufnahme der Kontaktflächen und des integrierten Schaltkreises, wie in den Fig. 2 und 3 dargestellt, verzichtet werden kann. Abschließend sei bemerkt, daß die Ausgestaltung des elektronischen Moduls gemäß Fig. 6 nur beispielhaft gewählt ist. Selbstverständlich kann das elektronische Modul auch anders aufgebaut sein, wobei jedoch die standardisierten Außenabmessungen des Moduls beibehalten werden, um eine einfache Herstellung der an die Außenabmessungen des Moduls angepaßten Aussparung des Kartenkörpers zu ermöglichen.

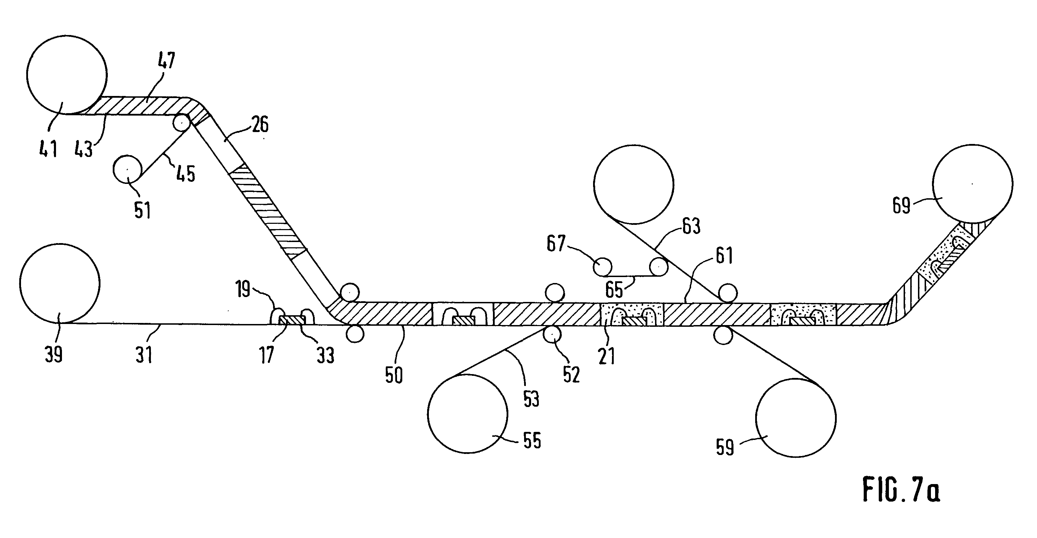

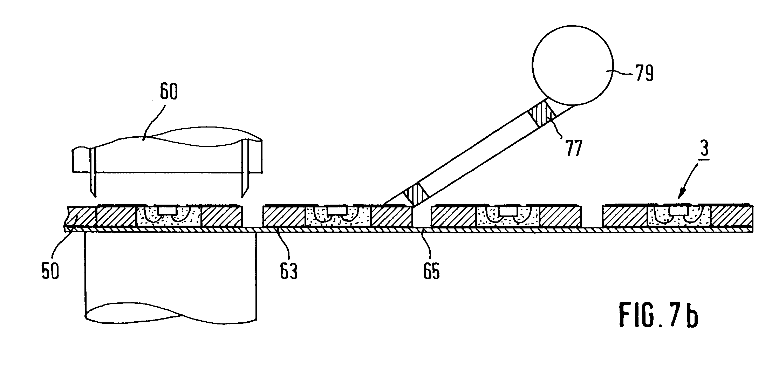

Fig. 7a und 7b zeigen in schematischer Darstellung ein Ausführungsbeispiel zur Halbzeugfertigung elektronischer Module. Von einer Rolle 39 wird das Metallband 31 abgewikkelt, in das mit einem nicht dargestellten Stanzwerkzeug das in Fig. 5 gezeigte Kontaktlayout vorgestanzt wird. In einer weiteren, ebenfalls nicht gezeigten Verarbeitungsstation wird auf einem zentralen Bereich der Kontaktflächen 5 ein integrierter Schaltkreis 17 aufgebracht, der durch elektrisch leitende Verbindungselemente 19 mit den Kontaktflächen leitend verbunden wird. Parallel zu den obengenannten Verfahrensschritten wird von einer Rolle 43 ein in Form von Endlosmaterial zugeführtes flexibles Band 47 abgerollt, aus dem die Adapterelemente 25 gefertigt werden. Zur Fertigung der Adapterelemente kann das Band wenigstens auf einer Seite 43 mit einer Klebeschicht versehen werden, die von einer Schutzfolie 45 abgedeckt ist. Das in Form von Endlosmaterial zugeführte flexible Band kann mit Öffnungen 26 versehen werden, die mittels einer nicht dargestellten Verarbeitungsstation, beispielsweise durch Stanzen, Bohren oder mittels anderer Techniken erzeugt werden. Von dem mit Öffnungen versehenen flexiblen Band wird die Schutzfolie 45 abgezogen und auf einer Rolle 51 aufgewickelt. Das mit den integrierten Schaltkreisen 17 versehene Metallband 31 wird mit dem mit den Öffnungen 26 versehenen Band derart zusammengeführt, daß wenigstens die integrierten Schaltkreise 17 und die elektrisch leitenden Verbindungselemente 19 in den Öffnungen 26 liegen. Das flexible Band wird mittels einer auf der Seite 43 befindlichen Klebeschicht mit dem Metallband verklebt. Danach kann der derart erhaltene Verbund 50 an der unteren Seite 52 mit einem schwachklebenden Band 53, das von einer Rolle 55 abgewickelt wird, zusammengeführt und leicht verklebt werden. Das Band 53 deckt die den integrierten Schaltkreisen gegenüberliegende Seite des Metallbandes derart ab, daß die integrierten Schaltkreise 17 und die elektrisch leitenden Verbindungselemente 19 an einer nicht gezeigten Verarbeitungsstation mit einer Gußmasse 21 vergossen werden können, ohne daß die Gußmasse durch die Unterbrechungen in dem Kontakt-Layout der Kontaktflächen 5 auf diese fließen kann. Bei dem Vergießen dienen die Wände der Öffnungen 26 als Begrenzungsrahmen für die Vergußmasse, so daß ein seitliches Abfließen der Vergußmasse verhindert wird. Nach diesem Verfahrensschritt kann das Band 53 wieder von dem Verbund 50 abgezogen und auf einer Rolle 59 aufgewickelt werden. Schließlich kann der Verbund 50 auf der oberen Seite 61 mit einem beidseitig klebenden Klebeband 63 versehen werden, von dessen einer Seite zuvor die Schutzfolie 65 entfernt und auf einer Rolle 67 aufgewickelt wird, so daß das Klebeband 63 mit dem Verbund verklebt werden kann. Die andere Seite des Klebebandes bleibt weiterhin mit einer Schutzfolie versehen. Der nunmehr fertiggestellte Verbund 50 kann auf einer Rolle 69 aufgewickelt oder aber auch sofort weiterverarbeitet werden.

In Fig. 7b ist die Weiterverarbeitung des Verbunds 50 zu einzelnen elektronischen Modulen gezeigt, die in die Aussparungen der Kartenkörper eingebaut werden. In einer ersten Station 60 wird aus dem Verbund 50 die Kontur der einzelnen elektronischen Module 3 gestanzt. Die Stanzung erfolgt hierbei derart, daß die in Fig. 5 gezeigten Verbindungsstege und das Klebeband 63 entsprechend der gewünschten Kontur der elektronischen Module durchtrennt werden, jedoch die Schutzfolie 65 nicht durchtrennt wird. Das nach dem Stanzvorgang übrig bleibende Stanzgitter 77 kann auf einer Rolle 79 aufgewickelt werden, so daß nur noch die einzelnen Module 3 auf der Schutzfolie verbleiben.

Abschließend sei erwähnt, daß an Stelle des gezeigten Metallbandes auch ein bereits mit integrierten Schaltkreisen bestücktes Band bereitgestellt werden kann. Als Trägerfilm für die bereits verdrahteten und vergossenen integrierten Schaltkreise kann selbstverständlich auch Kapton verwendet werden. Vorzugsweise sind die integrierten Schaltkreise sowie die elektrisch leitenden Verbindungen zum besseren Schutz von einer Gußmasse umgeben, jedoch ist das Vergießen der integrierten Schaltkreise und der elektrisch leitenden Verbindungen nicht zwingend notwendig.

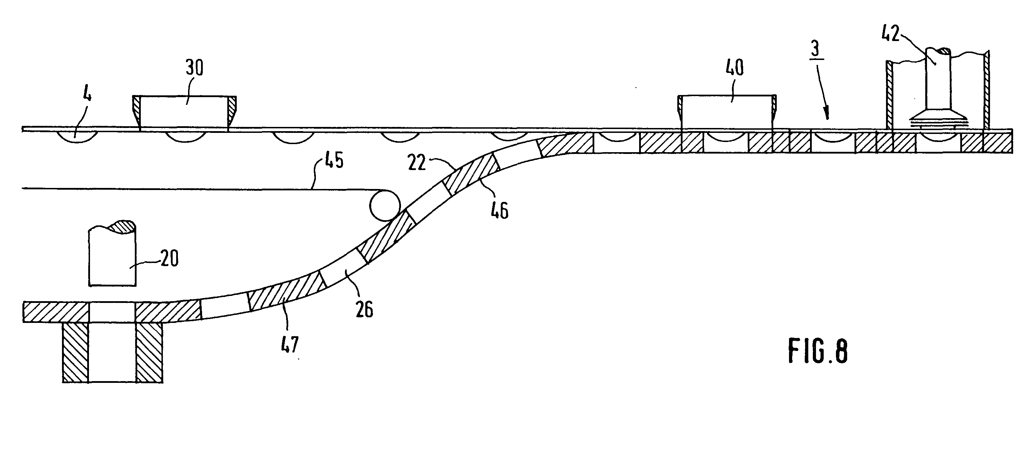

Fig. 8 zeigt in schematischer Darstellung ein Verfahren zur Herstellung von Ausweiskarten. Das in Form von Endlosmaterial zugeführte flexible Band 47 wird in einer Stanzstation 20 mit Öffnungen 26 versehen und wird nach Abziehen einer oberen Schutzfolie 45 mit den in Form von Endlosmaterial zugeführten Trägerelementen 4 mittels einer Klebeschicht 22 verbunden. In einer Stanzstation 30 wird die z. B. gewünschte Modulkontur vorgestanzt. Durch dieses Vorstanzen können die Trägerelemente anschließend einfacher mit den Adapterelementen in der Stanzstation 40 ausgestanzt werden, wobei diese dann nur noch von einem Stanzgitter umgeben sind. Die untere Schutzfolie 46 des flexiblen Bandes wird dabei nicht mitgestanzt. Von dieser Schutzfolie können dann die ausgestanzten elektronischen Module 3, bestehend aus Trägerelement und Adapterelement, mittels eines Sauggreifers 42 entnommen und in die Kartenaussparung eingeseztzt werden.
Die elektronischen Module können entweder direkt von dem Sauggreifer aus dem Stanzgitter entnommen werden, wodurch z. B. eine weitere Klebeschicht des flexiblen Bandes freigelegt wird und mittels dieser können dann die Module in die Kartenaussparung eingebaut werden. Es ist aber auch möglich, das Stanzgitter zuerst von der Schutzfolie 46 abzuziehen und auf eine nicht dargestellte Rolle aufzuwickeln und anschließend die in regelmäßigen Abständen auf der Schutzfolie 46 verbleibenden elektronischen Module zu entnehmen, um diese in die Kartenaussparungen einzubauen.

Auch kann zur Vergrößerung der Klebeflächen, wie dies z. B. in Fig. 3 dargestellt ist, das Adapterelement in einer nicht dargestellten Station entsprechend den Abmessungen der vergossenen integrierten Schaltkreise vorgeformt und anschließend mit einem gegenüber den vergossenen integrierten Schaltkreisen kleineren Durchgangsloch versehen werden. Dies hat den Vorteil, daß der vergossene integrierte Schaltkreis bei der Montage keinen mechanischen Überbeanspruchungen ausgesetzt wird.

## Patentansprüche

1. Verfahren zur Herstellung von Ausweiskarten (1), welches Kartenkörper (7) mit normierten Außenabmessungen verwendet, und bei dem Trägerelemente (4) mit unterschiedlichen Abmessungen, in die Kartenkörper (7) eingebaut werden, die Trägerelemente (4) wenigstens einen integrierten Schaltkreis (17) aufweisen, der elektrisch leitend mit Kopplungselementen (5) verbunden ist, die zur Kommunikation des integrierten Schaltkreises (17) mit externen Geräten dienen, **dadurch gekennzeichnet, daß**
- zur Aufnahme der unterschiedlichen Trägerelemente (4) Adapterelemente (25) bereitgestellt werden, die hinsichtlich der Außenabmessungen einheitlich ausgebildet sind,
- die Kartenkörper (7) zur Aufnahme der Adapterelemente (25) mit Aussparungen (9) versehen werden, die hinsichtlich der Form und Größe im wesentlichen den äußeren Abmessungen der Adapterelemente (25) entsprechen und daß,
- die Trägerelemente (4) über die Adapterelemente (25) mit dem Kartenkörper (7) verbunden werden.

2. Verfahren nach Anspruch 1, **dadurch gekennzeichnet, daß** in die Aussparungen (9) der Kartenkörper (7) zuerst die Adapterelemente (25) eingesetzt und zumindest teilweise mit den Kartenkörpern (7) verbunden werden und anschließend die Trägerelemente (4) eingesetzt und mit den Adapterelementen (25) verbunden werden.

3. Verfahren nach Anspruch 1, **dadurch gekennzeichnet, daß** zuerst die Trägerelemente (4) mit den Adapterelementen (25) mittels einer Klebeschicht (22, 29) zu Modulen verbunden werden und anschließend der Einbau dieser Module in die dafür vorgesehenen Aussparungen (9) der Kartenkörper (7) derart erfolgt, daß diese Module zumindest teilweise mit den Kartenkörpern verbunden sind.

4. Verfahren nach Anspruch 3, **dadurch gekennzeichnet, daß** die Trägerelemente (4) in Form von Endlosmaterial bereitgestellt werden,
- ein flexibles Band (47) in Form von Endlosmaterial zugeführt wird, aus dem die Adapterelemente (25) gefertigt werden,
- das flexible Band (47) in regelmäßigen Abständen mit Öffnungen (26) zur Aufnahme der Trägerelemente versehen wird,
- das mit Öffnungen (26) versehene Band (47) derart positioniert mit den Trägerelementen (4) zusammengeführt wird, daß die integrierten Schaltkreise (17) und die elektrisch leitenden Verbindungen (19) vollständig in den Öffnungen (26) des Bandes (47) liegen,
- die Trägerelemente (4) mit dem flexiblen Band (47) zu einem Verbund verklebt werden und daß,
- anschließend aus dem Verbund die elektronischen Module ausgestanzt werden.

5. Verfahren nach Anspruch 4, **dadurch gekennzeichnet, daß** die ausgestanzten Module mit Hilfe eines Sauggreifers (42) entnommen werden und mittels einer Klebeschicht in die Aussparungen (9) der Kartenkörper eingebaut werden.

6. Verfahren nach Anspruch 4, **dadurch gekennzeichnet , daß** als Endlosmaterial für die Trägerelemente ein Metallband (5) bereitgestellt wird.

7. Verfahren nach Anspruch 6, **dadurch gekennzeichnet, daß**
- aus dem Metallband (31) das für die Kontaktflächen (5) der elektronischen Module vorgesehene Kontaktlayout vorgestanzt wird, wobei die Kontaktflächen zunächst über Stege (35) mit dem Metallband verbunden bleiben,
- auf den zentralen Bereichen der Kontaktflächen die integrierten Schaltkreise (17) elektrisch leitend aufgeklebt und mit den Kontaktflächen elektrisch leitend verbunden werden,
- das Metallband (31) und das flexible Band zu einem Verbund verklebt werden,
- der Verbund in regelmäßigen Abständen entsprechend der Kontur der elektronischen Module derart mit Stanzungen versehen wird, daß die verbleibenden Stege des Metallbandes (31) und das flexible Band (47) durchtrennt werden, so daß einzelne elektronische Module ausgebildet werden, die von einem Stanzgitter umgeben sind.

8. Verfahren nach Anspruch 7, **dadurch gekennzeichnet, daß** der Verbund vor der Stanzung auf der Kontaktflächenseite mit einer Schutzfolie (65) versehen wird und die integrierten Schaltkreise (17) und die elektrisch leitenden Verbindungen (19) mit einer Gußmasse (21) vergossen werden, wobei während des Vergießens die Kontaktflächenseite der Module von der Schutzfolie abgedeckt wird.

9. Ausweiskartenserie (1), deren Karten jeweils ein vorgefertigtes Trägerelement (4) das in einer Aussparung (9) des Kartenkörpers (7) der Ausweiskarte angeordnet ist und wenigstens einen integrierten Schaltkreis (17) aufweisen, der elektrisch leitend über Verbindungselemente (19) mit auf dem Trägerelement angeordneten Kopplungselementen (5) verbunden ist, die zur Kommunikation des integrierten Schaltkreises mit externen Geräten dienen, **dadurch gekennzeichnet, daß** die Aussparung (9) des Kartenkörpers aller Karten der Serie die gleichen Abmessungen hat, in der ein zwei Hauptflächen aufweisendes Adapterelement (25) angeordnet ist, und eine der Hauptflächen des Adapterelementes (25) mit dem Boden der Aussparung (9) des Kartenkörpers (7) verbunden ist und die andere Hauptfläche des Adapterelementes (25) zumindest teilweise mit dem Trägerelement (4) verbunden ist, wobei das Adapterelement eine Aussparung aufweist, die an die Form und Größe unterschiedlicher Trägerelemente angepaßt ist und in welche das Trägerelement eingesetzt ist.

10. Ausweiskartenserie nach Anspruch 9, **dadurch gekennzeichnet, daß** mittels beidseitig auf dem Adapterelement (25) angeordneter Klebeschichten 29) das Adapterelement (25) mit dem Trägerelement (4) und dem Kartenkörper (7) verbunden ist.

11. Ausweiskarte (1) mit einem Trägerelement (4), das in einer Aussparung (9) des Kartenkörpers (7) der Ausweiskarte angeordnet ist und wenigstens einen integrierten Schaltkreis (17) aufweist, der elektrisch leitend über Verbindungselemente (19) mit Kopplungselementen (5) verbunden ist, die zur Kommunikation des integrierten Schaltkreises mit externen Geräten dienen, **dadurch gekennzeichnet, daß** in der Aussparung (9) des Kartenkörpers ein zwei Hauptflächen aufweisendes Adapterelement (25) aus elastischem oder plastisch leicht deformierbaren Material angeordnet ist, wobei mittels beidseitig auf dem Adapterelement (25) angeordneter Klebeschichten (22, 29) das Adapterelement (25) mit dem Trägerelement (4) und dem Kartenkörper (7) verbunden ist.

12. Ausweiskarte nach Anspruch 10 oder 11, **dadurch gekennzeichnet, daß** die Klebeschichten (22, 29) Haftkleber oder thermoaktivierbare Kleber sind.

13. Ausweisekarte nach Anspruch 12, **dadurch gekennzeichnet, daß** das Adapterelement (25) nur im mittleren Bereich mit dem Trägerelement (4) verklebt ist.

14. Ausweiskarte nach einem der Ansprüche 9 bis 13, **dadurch gekennzeichnet, daß** der integrierte Schaltkreis (17) und die elektrisch leitenden Verbindungselemente (19) des Trägerelements (4) von einer Gußmasse (21) umgeben sind, die zumindest teilweise mit dem Adapterelement (25) verbunden ist.

15. Ausweiskarte nach einem der Ansprüche 9 bis 14, **dadurch gekennzeichnet, daß** die Hauptflächen des Adapterelementes (25) asymmetrisch ausgebildet sind.

16. Ausweiskarte nach einem der Ansprüche 9 bis 15, **dadurch gekennzeichnet, daß** das Adapterelement aus elastischem oder plastisch leicht deformierbaren Material besteht.

17. Ausweiskarte nach einem der Ansprüche 9 bis 16, **dadurch gekennzeichnet, daß** das Adapterelement (25) aus einem Weich-PVC-Schaum oder Polyäthylen-Schaum oder Elastomer-Schaum oder einer PEL-Folie besteht.

18. Ausweiskarte nach einem der Ansprüche 9 bis 17, **dadurch gekennzeichnet, daß** die Kontaktflächen (5) aus einem Metallband (31) vorgestanzt sind.

## Claims

1. A method for producing identity cards (1) which uses card bodies (7) with standardized outer dimensions and wherein carrier elements (4) with different dimensions are incorporated in the card bodies (7), the carrier elements (4) having at least one integrated circuit (17) connected electroconductively with coupling elements (5) used for communication of the integrated circuit (17) with external devices, **characterized in that**
- adapter elements (25) formed with uniform outer dimensions are provided for receiving the different carrier elements (4),
- for receiving the adapter elements (25) the card bodies (7) are provided with recesses (9) corresponding in shape and size substantially to the outer dimensions of the adapter elements (25), and
- the carrier elements (4) are connected with the card body (7) via the adapter elements (25).

2. A method according to claim 1, **characterized in that** the adapter elements (25) are first inserted in the recesses (9) in the card bodies (7) and connected at least partly with the card bodies (7), and the carrier elements (4) are then inserted and connected with the adapter elements (25).

3. A method according to claim 1, **characterized in that** the carrier elements (4) are first connected with the adapter elements (25) by means of an adhesive layer (22, 29) to form modules, and said modules are then incorporated in the specially provided recesses (9) in the card bodies (7) in such a way that said modules are connected at least partly with the card bodies.

4. A method according to claim 3, **characterized in that** the carrier elements (4) are provided in the form of endless material,
- a flexible band (47) is fed in the form of endless material from which the adapter elements (25) are prepared,
- the flexible band (47) is provided at regular intervals with openings (26) for receiving the carrier elements,
- the band (47) provided with openings (26) is brought together with the carrier elements (4) positioned in such a way that the integrated circuits (17) and electroconductive connections (19) lie completely within the openings (26) of the band (47),
- the carrier elements (4) are glued to the flexible band (47) to form a compound, and
- the electronic modules are then stamped out of the compound.

5. A method according to claim 4, **characterized in that** the stamped-out modules are removed with the aid of a vacuum gripper (42) and incorporated in the recesses (9) in the card bodies by means of an adhesive layer.

6. A method according to claim 4, **characterized in that** a metal band (5) is provided as endless material for the carrier elements.

7. A method according to claim 6, **characterized in that**
- the contact layout intended for the contact surfaces (5) of the electronic modules is prestamped from the metal band (31), the contact surfaces first remaining connected with the metal band via bars (35),
- the integrated circuits (17) are glued electroconductively to the central areas of the contact surfaces and connected electroconductively with the contact surfaces,
- the metal band (31) and the flexible band are glued to form a compound,
- the compound is provided with stampings at regular intervals in accordance with the contour of the electronic modules in such a way that the remaining bars of the metal band (31) and the flexible band (47) are severed so as to form individual electronic modules surrounded by a stamping grid.

8. A method according to claim 7, **characterized in that** the compound is provided, before stamping, with a protective film (65) on the contact surface side and the integrated circuits (17) and electroconductive connections (19) are cast with a casting compound (21), the contact surface side of the modules being covered by the protective film during casting.

9. An identity card series (1) whose cards each have a prefabricated carrier element (4) which is disposed in a recess (9) in the card body (7) of the identity card and has at least one integrated circuit (17) connected electroconductively via connecting elements (19) with coupling elements (5) also disposed on the carrier element and used for communication of the integrated circuit with external devices, **characterized in that** the recesses (9) in the card bodies of all cards of the series have the same dimensions, each having disposed therein an adapter element (25) with two main surfaces, and one of the main surfaces of the adapter element (25) is connected with the bottom of the recess (9) in the card body (7) and the other main surface of the adapter element (25) is connected at least partly with the carrier element (4), the adapter element having a recess which is adapted in shape and size to different carrier elements and in which the carrier element is inserted.

10. An identity card series according to claim 9, **characterized in that** the adapter element (25) is connected with the carrier element (4) and the card body (7) by means of adhesive layers (29) disposed on both sides of the adapter element (25).

11. An identity card (1) having a carrier element (4) which is disposed in a recess (9) in the card body (7) of the identity card and has at least one integrated circuit (17) connected electroconductively via connecting elements (19) with coupling elements (5) used for communication of the integrated circuit with external devices, **characterized in that** the recess (9) in the card body has disposed therein an adapter element (25) made of elastic or plastically very deformable material and having two main surfaces, the adapter element (25) being connected with the carrier element (4) and the card body (7) by means of adhesive layers (22, 29) disposed on both sides of the adapter element (25).

12. An identity card according to claim 10 or 11, **characterized in that** the adhesive layers (22, 29) are contact adhesive or thermally activated adhesive.

13. An identity card according to claim 12, **characterized in that** the adapter element (25) is glued to the carrier element (4) only in the middle area.

14. An identity card according to any of claims 9 to 13, **characterized in that** the integrated circuit (17) and electroconductive connecting elements (19) of the carrier element (4) are surrounded by a casting compound (21) connected at least partly with the adapter element (25).

15. An identity card according to any of claims 9 to 14, **characterized in that** the main surfaces of the adapter element (25) are formed asymmetrically.

16. An identity card according to any of claims 9 to 15, **characterized in that** the adapter element consists of elastic or plastically very deformable material.

17. An identity card according to any of claims 9 to 16, **characterized in that** the adapter element (25) consists of soft PVC foam or polyethylene foam or elastomer foam or a PET film.

18. An identity card according to any of claims 9 to 17, **characterized in that** the contact surfaces (5) are prestamped from a metal band (31).

## Revendications

1. Procédé de fabrication de cartes d'identité (1), utilisant des corps de carte (7) ayant des dimensions extérieures normalisées, et pour lequel des éléments support (4) ayant des dimensions différentes, dans lesquelles sont intégrés les corps de carte (7), présentent les éléments support (4) d'au moins un circuit intégré (17), qui est relié de façon électriquement conductrice à des éléments de couplage (5), servant à la communication du circuit intégré (17) avec des appareils externes, **caractérisé en ce que**
- pour recevoir les différents éléments support (4) sont préparés des éléments adaptateurs (25) réalisés de façon unitaire du point de vue des dimensions extérieures,
- les corps de carte (7) sont munis, pour recevoir les éléments adaptateurs (25), d'évidements (9) qui, du point de vue de la forme et de la taille, correspondent sensiblement aux dimensions extérieures des éléments adaptateurs (25), et **en ce que**
- les éléments support (4) sont reliés aux corps de carte (7) par l'intermédiaire des éléments adaptateurs (25).

2. Procédé selon la revendication 1, **caractérisé en ce que** dans les évidements (9) des corps de carte (7) sont d'abord insérés les éléments adaptateurs (25) et ceux-ci sont reliés au moins partiellement aux corps de carte (7) et, ensuite, les éléments support (4) sont insérés et reliés aux éléments adaptateurs (25).

3. Procédé selon la revendication 1, **caractérisé en ce que**, d'abord, les éléments support (4) sont reliés aux éléments adaptateur (25), au moyen d'une couche d'adhésif (22, 29) pour former des modules et, ensuite, l'intégration de ces modules dans les évidements (9), prévus à cette fin, des corps de carte (7) s'effectue de manière que ces modules soient reliés au moins partiellement aux corps de carte.

4. Procédé selon la revendication 3, **caractérisé en ce que** les éléments support (4) sont préparés sous la forme de matériau continu,
- une bande flexible (27) se présentant sous la forme de matériau continu étant amenée, d'où sont fabriqués les éléments adaptateurs (25),
- la bande flexible (47) est munie, selon des espacements réguliers, d'ouvertures (26) devant recevoir des éléments support,
- la bande (47) munie des ouvertures (26) est groupée de façon positionnée avec les éléments support (4) de manière que les circuits intégrés (17) et les liaisons (19) conductrices de l'électricité soient situés complètement dans les ouvertures (26) de la bande (47),
- les éléments support (4) avec la bande flexible (47) sont collés pour former un composite, et **en ce que**,
- ensuite, à partir du composite, on découpe par estampage les modules électroniques.

5. Procédé selon la revendication 4, **caractérisé en ce que** les modules estampés sont prélevés à l'aide d'un preneur aspirant ou ventouse (42) et intégrés dans les évidements (9) des corps de carte à l'aide d'une couche d'adhésif.

6. Procédé selon la revendication 4, **caractérisé en ce qu'**on prépare une bande métallique (5), comme matériau continu pour les éléments support.

7. Procédé selon la revendication 6, **caractérisé en ce que**
- à partir de la bande métallique (31) on découpe par pré-estampage le schéma de contact prévu pour les faces de contact (5) du module électronique, les faces de contact restant en un premier stade reliées à la bande métallique par des nervures (35),
- sur les zones centrales des surfaces de contact, les circuits intégrés (17) sont appliqués par collage conducteur de l'électricité, et reliés de façon conductrice de l'électricité aux faces de contact,
- la bande métallique (31) et la bande flexible sont collées pour former un composite,
- le composite est muni sous des espacements réguliers, de manière correspondante aux contours du module électronique, de découpes d'estampage, de manière que les nervures subsistantes de la bande métallique (31) et de la bande flexible (47) soient détachées de sorte que soient formés des modules électroniques individuels entourés par une grille issue de l'estampage.

8. Procédé selon la revendication 7, **caractérisé en ce que** le composite est muni avant l'estampage, sur le côté face de contact, d'une feuille protectrice (65), et les circuits intégrés (17) et les liaisons conductrices de l'électricité (19) sont collées avec une masse de coulée (21), le côté des faces de contact des modules étant couvert par la feuille protectrice pendant l'opération de coulée.

9. Série de cartes d'identité (1) dont chacune des cartes présente un élément support (4) préfabriqué, disposé dans un évidement (9) du corps de carte (7) de la carte d'identité, et au moins un circuit intégré (17), circuit relié de façon conductrice de l'électricité par des éléments de liaison (19) à des éléments de couplage (5) disposés sur l'élément support, qui servent à la communication du circuit intégré avec des appareils externes, **caractérisée en ce que** l'évidement (9) du corps de carte de toutes les cartes de la série a les mêmes dimensions, évidement dans lequel est disposé un élément adaptateur (25) présentant deux faces principales et l'une des faces principales de l'élément adaptateur (25) est relié au fond de l'évidement (9) du corps de carte (7) et l'autre face principale de l'élément adaptateur (25) est reliée au moins partiellement à l'élément support (4), l'élément adaptateur présentant un évidement adapté à la forme et à la taille des différents éléments support dans lequel est inséré l'élément support.

10. Série de cartes d'identité selon la revendication 9, **caractérisée en ce qu'**au moyen de couches d'adhésif (29) disposées des deux côtés sur l'élément adaptateur (25), cet élément adaptateur (25) est relié à l'élément support (4) et au corps de carte (7).

11. Carte d'identité (1) avec un élément support (4), disposé dans un évidement (9) du corps de carte (7) de la carte d'identité et présentant au moins un circuit intégré (17) relié de façon conductrice de l'électricité, par l'intermédiaire d'éléments de liaison (19), à des éléments de couplage (5), servant à la communication du circuit intégré avec des appareils externes, **caractérisée en ce que**, dans l'évidement (9) du corps de carte, est disposé un élément adaptateur (25) présentant deux faces principales et formé d'un matériau légèrement déformable de façon élastique ou plastique, l'élément adaptateur (25) étant relié à l'aide de couches d'adhésif (22, 29) disposées des deux côtés sur l'élément adaptateur (25) à l'élément support (4) et au corps de carte (7).

12. Carte d'identité selon la revendication 10 ou 11, **caractérisée en ce que** les couches d'adhésif (22, 29) sont formées d'un auto-adhésif ou d'un adhésif thermoactivable.

13. Carte d'identité selon la revendication 12, **caractérisée en ce que** l'élément adaptateur (25) n'est collé à l'élément support (4) que dans la zone centrale.

14. Carte d'identité selon l'une des revendications 9 à 13, **caractérisée en ce que** le circuit intégré (17) et les éléments de liaison (19) conducteurs de l'électricité de l'élément support (4) sont entourés par une masse coulée (21) reliée au moins partiellement à l'élément adaptateur (25).

15. Carte d'identité selon l'une des revendications 9 à 14, **caractérisée en ce que** les faces principales de l'élément adaptateur (25) sont asymétriques.

16. Carte d'identité selon l'une des revendications 9 à 15, **caractérisée en ce que** l'élément adaptateur est constitué d'un matériau légèrement déformable de façon élastique ou plastique.

17. Carte d'identité selon l'une des revendications 9 à 16, **caractérisée en ce que** l'élément adaptateur (25) est constitué d'une mousse de PVC souple, ou bien d'une mousse de polyéthylène, ou d'une mousse d'élastomère, ou d'une feuille de PEL.

18. Carte d'identité selon l'une des revendications 9 à 17, **caractérisée en ce que** les faces de contact (5) sont obtenues par pré-estampage depuis une bande métallique (31).
